# FASCICULE DE BREVET EUROPEEN

(11) **EP 2 608 401 B1**
(45) Date de publication et mention de la délivrance du brevet: **27.03.2019**
(21) Numéro de dépôt: 11194995.4
(22) Date de dépôt: 21.12.2011
(51) Int. Cl.: H03F 1/32, H03F 3/19, H03F 1/02, H03F 1/22, H03F 3/21, H03F 3/24, H03F 3/72, H04L 27/04

(54) **Circuit de transmission de signaux RF ASK avec adaptation des flancs des signaux de données**
Übertragungsschaltkreis für RF-ASK-Signale mit Anpassung der Flanken der Datensignale
Circuit for transmitting ASK RF signals with adaptation of the edges of the data signals

(43) Date de publication de la demande: 26.06.2013
(73) Titulaire: EM Microelectronic-Marin SA, 2074 Marin (CH)
(72) Inventeur: Moser, Michel, 1468 Cheyres (CH)
(74) Mandataire: Giraud, Eric

(56) Documents cités:
- US-A1- 2007 190 952
- US-A1- 2009 004 981
- US-A1- 2010 188 148
- US-B2- 7 560 989
- CHIEN-JUNG LI ET AL: "High Average-Efficiency Multimode RF Transmitter Using a Hybrid Quadrature Polar Modulator", IEEE TRANSACTIONS ON CIRCUITS AND SYSTEMS II: EXPRESS BRIEFS, IEEE, US, vol. 55, no. 3, 1 mars 2008 (2008-03-01), pages 249-253, XP011333847, ISSN: 1549-7747, DOI: 10.1109/TCSII.2008.918969
- BERND GEISER ET AL: "Bandwidth Extension for Hierarchical Speech and Audio Coding in ITU-T Rec. G.729.1", IEEE TRANSACTIONS ON AUDIO, SPEECH AND LANGUAGE PROCESSING, IEEE SERVICE CENTER, NEW YORK, NY, USA, vol. 15, no. 8, 1 novembre 2007 (2007-11-01), pages 2496-2509, XP011192970, ISSN: 1558-7916, DOI: 10.1109/TASL.2007.907330

## Description

La présente invention concerne un circuit électronique pour la transmission de signaux radiofréquences à modulation d'amplitude, et qui est muni de moyens de mise en forme des flancs des signaux de données à transmettre. Le circuit électronique comprend un amplificateur de puissance en sortie relié à une antenne pour la transmission de signaux RF ASK dans un système de communication sans fil.

Dans le domaine d'applications industrielles, scientifiques et médicales (ISM), les systèmes de communication sans fil utilisent typiquement des signaux à fréquence porteuse, qui est comprise dans des bandes de fréquence réservées à ces applications. La fréquence porteuse de tels signaux se situe généralement aux alentours de 434 MHz ou 868 MHz.

La largeur de bande spectrale de signaux RF ASK (Amplitude Shift Keying en terminologie anglaise) transmis, doit être en principe limitée pour ne pas perturber l'émission dans une bande de fréquence voisine d'un transmetteur à proximité et pour faciliter la réception des signaux par un récepteur à proximité. De ce fait, il peut être prévu par exemple de diminuer la puissance de sortie notamment dans l'amplificateur de puissance de sortie du circuit transmetteur. Il peut aussi être envisagé de réduire le débit de transmission des données, de coder les données en bande de base, ou d'adapter certaines techniques de modulation. Il peut encore être imaginé de contrôler les transitions entre deux symboles de données.

Dans le cas d'une utilisation d'un amplificateur de puissance en sortie de classe C pour un circuit transmetteur à haute efficacité, il est souvent difficile d'une part de limiter directement la largeur de bande des signaux à transmettre et d'autre part de diminuer facilement la puissance de sortie. Un tel circuit transmetteur à haute efficacité avec cet amplificateur de puissance de classe C n'est généralement pas linéaire. Il peut être prévu par exemple de monter un condensateur entre des bornes de grille et drain d'un transistor MOS de l'amplificateur de puissance. Cependant avec un tel agencement, cela diminue l'efficacité du circuit transmetteur. De plus, un tel agencement est généralement peu pratique pour de tels amplificateurs de puissance pour la transmission de signaux radiofréquences.

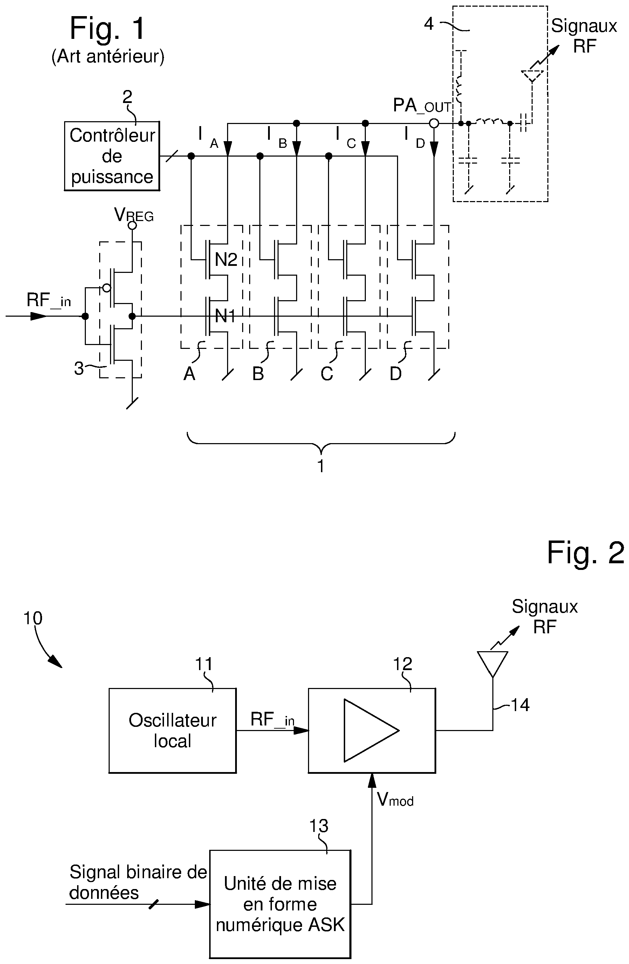

On peut citer le brevet US 7,560,989, qui décrit un circuit à amplificateur de puissance en sortie pour la transmission de signaux RF ASK comme représenté sur la figure 1. Ce circuit transmetteur comprend donc une unité à amplificateur de puissance 1 en sortie, qui est configurée de manière à contrôler la puissance de sortie désirée. L'unité à amplificateur de puissance 1 peut être connectée à un ensemble d'antenne 4, qui est montré sur la figure 1, en lignes interrompues depuis la borne de sortie PA_{_OUT} de l'unité à amplificateur de puissance 1. L'unité à amplificateur de puissance 1 comprend plusieurs cellules en parallèle d'amplification A, B, C, D, qui sont connectées généralement entre une borne de masse et la borne de sortie PA_{_OUT}. Lesdites cellules d'amplification sont dans cet exemple des cellules d'amplification en montage cascode, qui sont composées chacune de deux transistors N1 et N2 du type NMOS en série. Chaque cellule en fonction est susceptible d'être traversée par un courant variable déterminé I_{A}, I_{B}, I_{C}, I_{D}.

Un contrôleur de puissance 2 du circuit transmetteur permet de sélectionner une combinaison de cellules d'amplification à activer pour établir une puissance de sortie désirée pour la transmission des signaux de données ASK. La sélection de cellules d'amplification à activer permet ainsi d'obtenir un contrôle grossier d'amplitude, respectivement de puissance émise. Pour pouvoir activer une telle cellule d'amplification de l'unité à amplificateur de puissance, la grille d'un second transistor N2 est commandée par une tension de commande de niveau proche de la borne positive d'une source de tension d'alimentation. Chaque combinaison de cellules d'amplification activées définit un niveau prédéterminé de puissance, respectivement d'amplitude, du signal de sortie de l'unité à amplificateur de puissance.

Ledit circuit transmetteur à amplificateur de puissance comprend encore sans être représenté sur la figure 1, une cellule de référence, qui est une cellule réplique similaire à une des cellules d'amplification A, B, C, D, un générateur de courant et un générateur de tension. Le générateur de courant et le générateur de tension sont connectés au contrôleur de puissance 2. Le générateur de courant fournit un courant de référence, et le générateur de tension fournit une tension de référence. Le courant de référence est miroité dans la cellule réplique, qui est constituée de deux transistors MOS en montage cascode. Le courant miroité dans la cellule réplique permet de contrôler le courant dans chaque cellule activée de l'unité à amplificateur de puissance 1.

Un régulateur de tension du circuit à amplificateur de puissance permet encore de fixer une tension de régulation V_{REG} pour alimenter un inverseur, dont la sortie est connectée directement à la borne de grille de chaque premier transistor N1 de chaque cellule A, B, C, D de l'unité à amplificateur de puissance 1. Cet inverseur 3 reçoit en entrée un signal RF_in à fréquence porteuse désirée pour les signaux de données à transmettre. Par un enclenchement et une interruption du régulateur de tension, qui alimente l'inverseur 3, il est possible d'obtenir une modulation d'amplitude de données du type en tout ou rien (ON-OFF Keying en terminologie anglaise).

Une adaptation, visant à modifier la puissance ou la forme des signaux de données, peut ainsi être effectuée au moyen de la sélection de cellules d'amplification A, B, C, D ou également en adaptant le courant de référence miroité dans la cellule réplique. Toutefois, cela requiert un nombre considérable de composants électroniques pour réaliser cette adaptation, ce qui constitue un inconvénient. De plus, rien n'est prévu pour réduire suffisamment la largeur de bande des signaux RF ASK à transmettre, ce qui constitue un autre inconvénient.

Le document de brevet US 2007/0190952 divulgue un circuit pour la transmission de signaux radiofréquences à modulation d'amplitude comprenant une unité de ! mise en forme des impulsions des données.

Comme précédemment mentionné, l'utilisation de la modulation d'amplitude (ASK) est de manière générale à grande largeur de bande et il est souvent nécessaire de réduire ladite largeur de bande. A cette fin, il peut être prévu d'atténuer plus ou moins fortement les flancs des transitions de données pour réduire la largeur de bande effective du signal transmis. Pour ce faire, il peut être envisagé d'ajouter un troisième transistor en série avec les deux autres transistors dans chaque cellule d'amplification de l'unité à amplificateur de puissance du circuit transmetteur. Ce troisième transistor de chaque cellule d'amplification peut être commandé sur sa grille par un signal modulant du type ASK pour moduler l'amplitude des signaux RF à fréquence porteuse à transmettre. Les flancs de chaque transition dans les données à transmettre sont lissés ou atténués en variant progressivement la tension de grille de ce troisième transistor. La tension de grille varie progressivement sur la base d'une variation du courant de commande dans une boucle de commande du courant, qui comprend un générateur de rampes de courant. Ceci permet d'atténuer la rapidité de transition d'état dans les données à transmettre par les signaux RF ASK.

Cet agencement requiert également plusieurs filtres passe-bas configurables par un mot binaire entre une cellule réplique de la boucle de commande de courant et chaque cellule d'amplification pour adapter convenablement la forme de l'enveloppe des signaux RF ASK à transmettre. Pour toute modification du type de rampe de courant ou de l'enveloppe des signaux RF ASK à transmettre, il doit être modifié également la fonction de transfert de chaque filtre passe-bas dans le domaine analogique à l'entrée de l'amplificateur de puissance. Un tel filtre est réalisé dans une forme usuelle par un réseau comportant des condensateurs et des résistances et/ou un ou plusieurs amplificateurs opérationnels. Le filtre agit sur un signal en bande de base, ce qui entraîne des fréquences de coupure relativement basses. Ces fréquences de coupure sont typiquement configurables entre quelques kilohertz et quelques centaines de kilohertz. Les valeurs de capacité et de résistance requises sont dès lors relativement élevées, ce qui entraîne une surface importante d'intégration. Ceci constitue un inconvénient. L'adaptation des flancs de transition des données dans ce domaine analogique est également dépendante du procédé de fabrication utilisé. Les valeurs de résistance et de capacité du filtre, ainsi que les propriétés des transistors notamment dans l'amplificateur de puissance, varient en fonction du procédé de fabrication. Cela constitue un autre inconvénient. De plus, il doit être généré dans le domaine analogique plusieurs sources de courant de valeurs différentes, ce qui constitue un autre inconvénient.

L'invention a donc pour but de pallier aux inconvénients de l'état de la technique en fournissant un circuit de transmission de signaux radiofréquences à modulation d'amplitude numérique, qui comprend des moyens facilement paramétrables numériquement pour atténuer les flancs de transition des données des signaux RF ASK, et susceptibles d'occuper une surface de circuit intégré réduite.

A cet effet, l'invention concerne un circuit de transmission de signaux radiofréquences à modulation d'amplitude numérique, qui comprend les caractéristiques définies dans la revendication indépendante 1.

Des formes particulières d'exécution du circuit de transmission de signaux radiofréquence à modulation d'amplitude des données sont définies dans les revendications dépendantes 2 à 11.

Un avantage du circuit de transmission de signaux radiofréquences à modulation d'amplitude numérique réside dans le fait qu'il est utilisé des moyens numériques pour former les impulsions de données et pour atténuer des flancs de transition des données pour la transmission des signaux de données ASK. Un tel circuit numérique formeur d'impulsions peut être implémenté sous plusieurs formes d'exécution. Ces formes d'exécution ont comme caractéristique commune, que la forme de la transition entre deux symboles de données est définie par une ou plusieurs formes d'onde mémorisées sous forme d'une ou plusieurs séquences d'échantillons de valeurs numériques dans une mémoire du circuit. En reprogrammant cette mémoire, on peut facilement, selon l'application d'utilisation du circuit de transmission, adapter la forme des transitions entre les données. Le formeur d'impulsions peut par exemple comprendre un filtre en cosinus surélevé, qui peut être implémenté sous la forme d'un filtre à réponse impulsionnelle finie du type FIR.

Un avantage du circuit de transmission de signaux radiofréquences à modulation d'amplitude des données réside dans le fait que l'amplificateur de puissance peut être composé d'uniquement deux transistors de type MOS en série dans un montage cascode. Un des transistors est commandé sur sa grille par un signal oscillant à fréquence porteuse fourni par un oscillateur local, alors que l'autre transistor est commandé sur sa grille par la tension de modulation fournie par une unité de mise en forme du signal modulant ASK. La cellule de mise en forme du signal modulant comporte un convertisseur numérique-analogique simple, qui convertit le signal de sortie du formeur numérique d'impulsions dans le domaine analogique. Ce convertisseur numérique-analogique est suivi d'un filtre passe-bas à fréquence de coupure relativement élevée et à fonction de transfert peu sélective. La sortie dudit filtre passe-bas fournit le signal modulant à la grille du transistor de commande de l'amplificateur de puissance. L'intégration de tous ces composants pour l'adaptation numérique des flancs de données est ainsi plus facile, et moins de surface de circuit intégré est nécessaire pour cette intégration.

Les buts, avantages et caractéristiques du circuit de transmission de signaux radiofréquences à modulation d'amplitude apparaîtront mieux dans la description suivante sur la base d'au moins une forme d'exécution non limitative illustrée par les dessins sur lesquels :
la figure 1 citée ci-devant représente de manière simplifiée une partie de sortie d'un circuit transmetteur de signaux RF ASK à unité à amplificateur de puissance de l'état de la technique,
la figure 2 représente de manière simplifiée les différents blocs électroniques du circuit de transmission de signaux radiofréquences à modulation d'amplitude des données selon l'invention,
la figure 3 représente des graphiques comparatifs de la forme des signaux de données ASK dans le domaine temporel et dans le domaine fréquentiel pour un circuit de transmission des signaux RF ASK sans mise en forme des flancs de transition de l'état de la technique et un circuit de transmission des signaux RF ASK selon l'invention,
la figure 4 représente de manière plus détaillée les différents composants électroniques de l'unité pour former les impulsions et l'enveloppe des signaux de données ASK du circuit de transmission de signaux RF ASK selon l'invention,
la figure 5 représente différents graphiques temporels des signaux à l'entrée et à la sortie des composants électroniques de la partie numérique de l'unité pour former les impulsions et l'enveloppe des signaux de données ASK du circuit de transmission de signaux RF ASK selon l'invention,
la figure 6 représente une forme d'exécution détaillée de la conversion numérique-analogique et du filtrage passe-bas en sortie pour fournir une tension de commande de modulation des données de l'unité pour former les impulsions et l'enveloppe des signaux de données ASK du circuit de transmission de signaux RF ASK selon l'invention, et
la figure 7 représente un agencement électronique pour la génération des signaux de commutation pour la conversion numérique-analogique et le filtrage passe-bas de l'unité pour former les impulsions de données selon l'invention.

Dans la description suivante, tous les éléments électroniques du circuit de transmission de signaux radiofréquences à modulation d'amplitude des données, qui sont bien connus de l'homme du métier dans ce domaine technique ne seront relatés que de manière simplifiée.

La figure 2 représente de manière très générale le circuit 10 de transmission de signaux radiofréquences à modulation d'amplitude numérique. Le circuit 10 comprend essentiellement un oscillateur local 11, qui peut comprendre un synthétiseur de fréquence muni d'un oscillateur de référence relié à un résonateur à quartz. Cet oscillateur de référence peut fournir un signal de référence à une fréquence, qui peut être de l'ordre de 13.56 MHz. Cet oscillateur local peut fournir en sortie du synthétiseur de fréquence, un signal oscillant RF_in à l'entrée d'un amplificateur de puissance 12. Ce signal oscillant RF_in est généré à une fréquence porteuse déterminée pour la transmission des signaux RF ASK par l'antenne 14, qui est reliée à la sortie de l'amplificateur de puissance 12. La fréquence porteuse peut être choisie à 434 MHz ou 868 MHz.

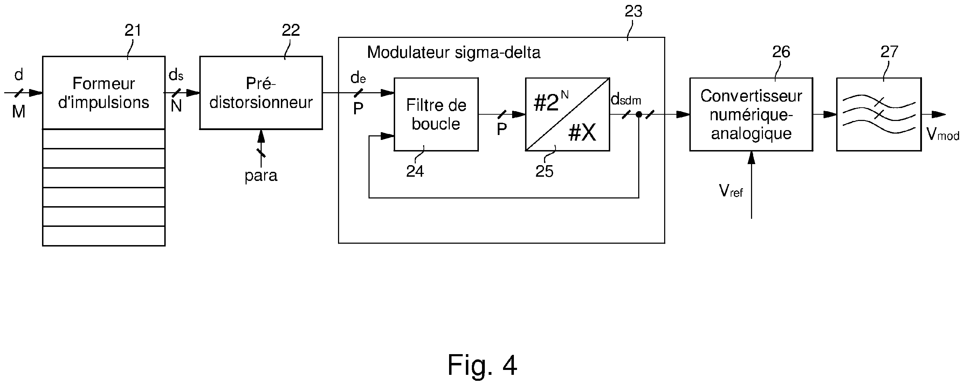

Le circuit 10 comprend encore une unité 13 de mise en forme numérique des impulsions de données à transmettre. Cette unité 13 de mise en forme reçoit en entrée un signal numérique de données pour la génération de signaux radiofréquences à modulation d'amplitude des données ASK à transmettre par l'antenne 14 du circuit 10. Le signal numérique de données, qui définit le signal modulant ou flux de données binaires, est sur M bits décrit ci-après en référence à la figure 4. La mise en forme des impulsions de données peut être programmée facilement dans cette partie numérique de l'unité 13 de mise en forme, qui effectue un filtrage numérique. Cela permet de facilement adapter numériquement les flancs de transition des données avec peu de composants électroniques, afin de diminuer la largeur de bande de fréquences des signaux RF ASK à transmettre par l'antenne. Ceci permet d'éviter de perturber d'autres transmetteurs à proximité émettant dans des bandes de fréquences voisines et de faciliter la réception des signaux par un récepteur à proximité.

Sur la base du signal numérique de données, l'unité 13 met donc en forme numériquement les impulsions rectangulaires des signaux de données ASK, afin de fournir après conversion numérique-analogique un signal de modulation Vmod. Ce signal de modulation est de préférence une tension de commande Vmod, qui est fournie à l'amplificateur de puissance pour moduler en amplitude les données sur le signal oscillant à fréquence porteuse RF_in.

L'amplificateur de puissance 12 peut avantageusement n'être constitué que d'une seule cellule à transistors de type MOS montés en série sous forme d'un montage cascode. Comme représenté à la figure 1, cette cellule de transistors MOS en montage cascode peut être composée de deux transistors en série du type NMOS. Le premier de ces transistors NMOS a sa source reliée par exemple à la borne de masse d'une source de tension d'alimentation du circuit de transmission 10, et son drain relié à la source du second transistor NMOS. Le drain du second transistor NMOS est relié à une borne de sortie du circuit de transmission 10, qui est reliée à l'antenne 14. Cette antenne 14 peut être sous la forme de préférence d'un agencement d'antenne comme représenté à la figure 1 pour la transmission de signaux RF ASK.

Le premier transistor NMOS peut être commandé, sur sa grille, par le signal oscillant RF_in, alors que le second transistor NMOS peut être commandé, sur sa grille, par la tension de modulation Vmod fournie par l'unité 13 de mise en forme numérique des impulsions de données. Comme l'unité 13 met en forme numériquement le signal modulant ASK, les flancs de données sont atténués numériquement dans l'unité sans l'utilisation de filtres passe-bas à basse fréquence de coupure, sélectifs et programmables à l'entrée de l'amplificateur de puissance 12.

Il est à noter que l'amplificateur de puissance 12 peut être réalisé d'une autre manière que celle susmentionnée. L'amplificateur de puissance doit comprendre essentiellement une première borne d'entrée à laquelle le signal oscillant RF_in est appliqué, et une seconde borne d'entrée, qui contrôle la modulation d'amplitude des données à transmettre dans les signaux RF ASK.

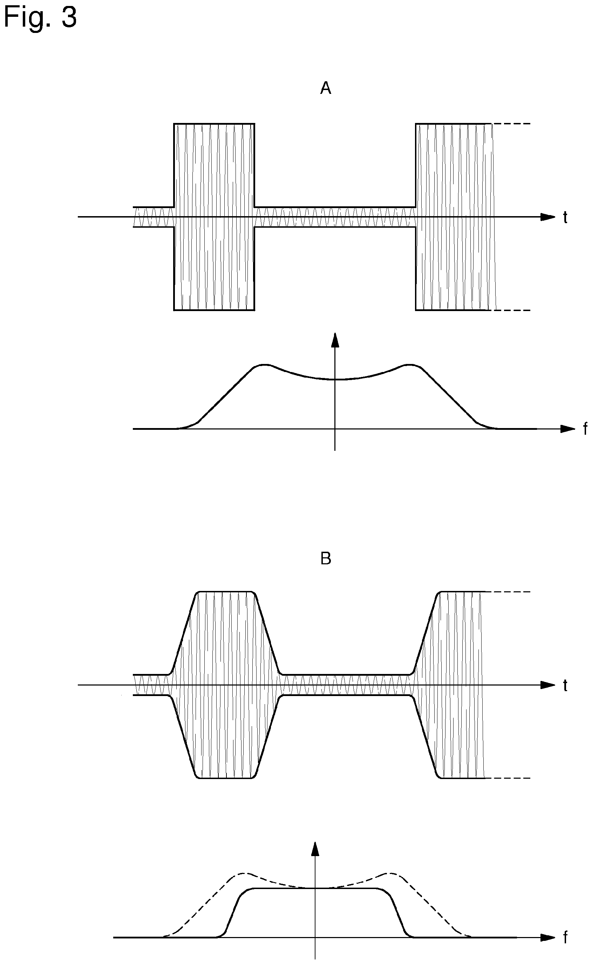

Sur la figure 3, il est représenté la différence de largeur de bande de fréquences des signaux radiofréquences à modulation d'amplitude des données ASK à transmettre pour un circuit transmetteur de l'état de la technique sous la référence A et un circuit transmetteur de la présente invention sous la référence B. On remarque sous la référence A, que les flancs de transition des données des signaux RF ASK dans le graphique temporel sont raides, ce qui génère une grande largeur de bande de fréquences occupée par le signal dans le spectre de fréquences. Par contre sous la référence B, on remarque une certaine atténuation ou lissage de flancs de transition des données dans le graphique temporel, ce qui réduit notablement la largeur de bande de fréquences représenté dans le spectre de fréquences, comme désiré. La différence de la largeur de bande sous la référence B est bien représentée comparativement à celle d'un circuit transmetteur de l'état de la technique indiquée en traits interrompus. Les impulsions rectangulaires des données sont générées en bande de base.

La figure 4 représente plus en détail une forme d'exécution de l'unité de mise en forme numérique des impulsions de données pour le circuit de transmission de signaux radiofréquences à modulation d'amplitude numérique. Cette unité comprend essentiellement un formeur d'impulsions 21 pour recevoir en entrée un signal numérique de données d sur M bits ou flux de données numériques. Ce signal numérique de données est de préférence un signal binaire dans un mode de non retour à zéro (NRZ) ayant un débit de l'ordre de 25 kBaud, c'est-à-dire 25'000 symboles par seconde. Ce signal numérique de données d est mis en forme numériquement dans le formeur d'impulsions 21, afin d'atténuer la pente des flancs de transition des données pour la modulation d'amplitude ASK. L'atténuation de chaque flanc de transition peut être définie entre 5 et 20% de la durée de chaque bit de données. Le formeur d'impulsions sur-échantillonne ce signal binaire d'un facteur 20, c'est-à-dire avec un débit de l'ordre de 500'000 échantillons par seconde. Il produit en sortie une forme d'onde filtrée dₛ, qui est codée sur N bits, par exemple sur 10 bits.

L'unité comprend encore en sortie un étage de conversion numérique-analogique 26, 27 pour convertir un signal numérique de données mis en forme dans l'unité en un signal de commande de modulation ASK Vmod. Ce signal de commande est de préférence une tension de modulation Vmod, qui est appliquée directement à une borne d'entrée de l'amplificateur de puissance de sortie du circuit de transmission. Ce signal de commande de modulation Vmod permet de moduler en amplitude les données sur le signal oscillant à fréquence porteuse fourni par l'oscillateur local pour la transmission de signaux RF ASK par l'antenne du circuit de transmission.

L'unité de mise en forme numérique des impulsions de données peut encore comprendre à la suite du formeur d'impulsions 21, un élément de pré-distorsion 22, qui reçoit du formeur d'impulsions un signal numérique de données mis en forme et filtré numériquement dₛ sur N bits ou flux de données numériques mis en forme. Cet élément de pré-distorsion est susceptible d'appliquer une caractéristique de transfert non linéaire au signal numérique de données mis en forme dₛ. Cela permet d'opérer une pré-distorsion du signal numérique de données mis en forme de manière à compenser toute distorsion sur le chemin des signaux de modulation jusqu'à l'antenne. Cet élément de pré-distorsion peut être nécessaire étant donné que l'amplificateur de puissance n'est en principe pas linéaire, notamment s'il s'agit d'un amplificateur de classe C. Cet élément de pré-distorsion comprend une mémoire, qui peut contenir une table de consultation pour établir une valeur de sortie sur la base de chaque valeur possible à l'entrée. Il peut également être paramétré facilement par un signal de paramétrage para, de manière à tenir compte également des conditions de fonctionnement du circuit de transmission et des paramètres du procédé de fabrication du circuit intégré.

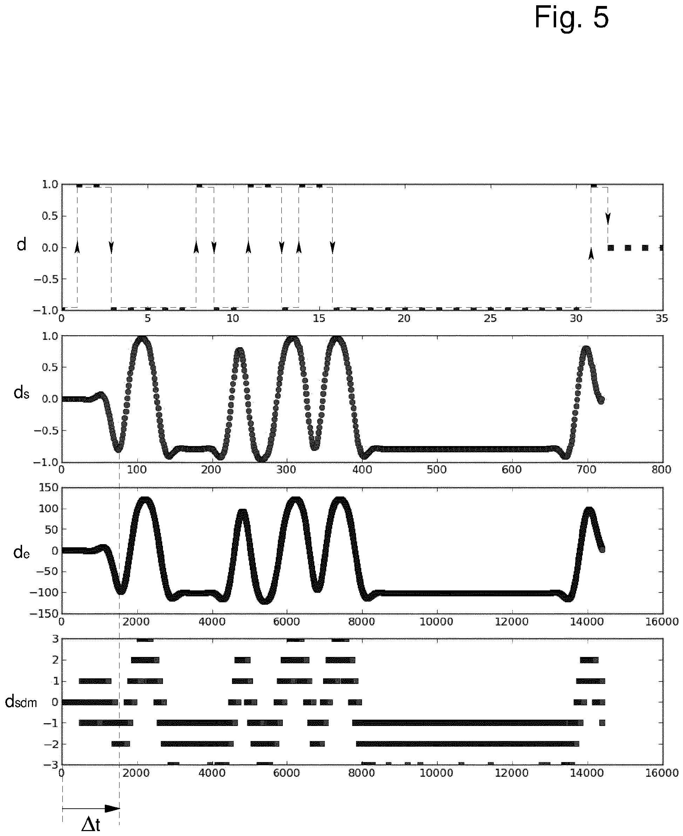

L'unité de mise en forme numérique des impulsions des données comprend encore un modulateur sigma-delta 23 à la suite de l'élément de pré-distorsion. Ce modulateur sigma-delta 23 reçoit le signal numérique de données mis en forme et pré-distordu dₑ sur P bits et fournit en sortie un signal numérique de données à plusieurs niveaux définis d_{sdm} pour un convertisseur numérique-analogique 26. Le nombre de bits P du signal dₑ peut être le même que celui du signal numérique mis en forme et filtré dₛ en sortie du formeur d'impulsions, c'est-à-dire 10 bits. Ce modulateur sigma-delta 23, bien connu, est purement un circuit numérique, qui est composé d'un filtre de boucle numérique 24 et d'un quantificateur 25 qui diminue les bits LSB. Le filtre de boucle 24 reçoit le signal numérique de données mis en forme et pré-distordu dₑ et le signal numérique de sortie d_{sdm}. Le quantificateur 25 reçoit un signal numérique filtré par le filtre de boucle 24. Ce quantificateur 25 est susceptible de quantifier le signal numérique filtré à P bits ou N bits relatif au signal numérique de données mis en forme et pré-distordu dₑ sur X niveaux définis dans le signal numérique quantifié de sortie d_{sdm}. Il peut être choisi de fournir un signal numérique quantifié de sortie d_{sdm} sur 2 niveaux, 4 niveaux, 5 niveaux ou 7 niveaux comme représenté à la figure 5 expliquée ci-après.

Il est à noter que la modulation sigma-delta n'est utile dans ce cas de figure, que si le nombre de niveaux en sortie est sensiblement plus faible que le nombre de niveaux en entrée. Ceci est le cas si le nombre de bits en entrée vaut par exemple 10, ce qui donne lieu à 2¹⁰ niveaux possibles en entrée, et le nombre de niveaux en sortie peut être de 7.

Grâce au filtre de boucle 24 dans le modulateur sigma-delta, le bruit de quantification de cette opération est supprimé dans la largeur de bande du signal modulant. Par contre, il subsiste des signaux parasites à fréquence plus élevée en dehors de la largeur de bande. Ces signaux parasites à fréquence élevée sont dus à la quantification et se trouvent distribués dans une bande de fréquences proche de la fréquence d'échantillonnage du modulateur sigma-delta. Ces signaux parasites sont supprimés par le filtre passe-bas 27 en sortie de l'unité de mise en forme numérique des impulsions de données.

Sur la base du signal numérique de données à plusieurs niveaux définis d_{sdm} fourni par le modulateur 23, et d'une tension de référence Vref, le convertisseur numérique-analogique 26 peut convertir le signal numérique en un signal de commande de modulation dans le domaine analogique. Ce signal de commande de modulation passe encore à travers le filtre passe-bas 27 non sélectif pour fournir un signal de commande de modulation filtré Vmod à l'amplificateur de puissance pour la modulation en amplitude des données. La fréquence de coupure de ce filtre passe-bas peut être choisie à 100 kHz.

Le formeur d'impulsions 21 comprend une mémoire dans laquelle peuvent être mémorisées, dans plusieurs registres, des formes adéquates des impulsions de modulation des données. Le signal numérique de données reçu à l'entrée du formeur d'impulsions est codé sur M bits et échantillonné à une première fréquence d'échantillonnage m fois supérieure à la fréquence des données, où m est un nombre entier supérieur ou égal à 2, de préférence égal à 20. Ainsi 2^{M} niveaux de modulation sont disponibles.

Dans le cas le plus simple de la modulation d'amplitude ON-OFF, M=1 et le nombre de niveaux est 2. Le premier signal d'échantillonnage des données pour le formeur d'impulsions peut être fourni par l'oscillateur local sur la base du signal de référence de l'oscillateur à quartz et d'un ou plusieurs diviseurs de fréquence. Dans le cas d'une fréquence du signal de référence de l'oscillateur à quartz choisie à 13.56 MHz, la première fréquence d'échantillonnage fs/n pour le formeur d'impulsions et l'élément de pré-distorsion 22, peut être de l'ordre de 678 kHz. Pour ce faire, le signal de référence passe par un ensemble de diviseurs de manière à diviser la fréquence de référence par un facteur n égal à 20. Par contre, l'échantillonnage opéré dans le modulateur sigma-delta 23, est effectué par un second signal d'échantillonnage à fréquence n fois supérieure à la première fréquence d'échantillonnage, où n est un nombre entier supérieur ou égal à 2. Ce second signal d'échantillonnage peut être directement obtenu sur la base du signal de référence de l'oscillateur local à une fréquence d'échantillonnage fs égale à 13.56 MHz.

Selon une première forme d'exécution du formeur d'impulsions, la meilleure efficacité spectrale peut être obtenue par l'utilisation d'un filtre à fréquence impulsionnelle finie du type FIR. Un exemple de réalisation d'un tel filtre FIR est décrit notamment dans la demande de brevet EP 0 383 326 A2 à la figure 1 et en description depuis la ligne 41, de la colonne 3. Ce filtre FIR permet de multiplier le spectre de signaux par exemple avec une fonction de transfert en cosinus surélevé. Un tel filtre FIR implémente la convolution du signal numérique de données reçu à l'entrée, avec une réponse impulsionnelle de longueur finie. Les échantillons de la réponse impulsionnelle sont mémorisés dans la mémoire. La fonction de transfert du filtre FIR peut être modifiée en choisissant de manière adéquate les valeurs des échantillons mémorisés. Cette implémentation est capable de couvrir des transitions de symboles, qui s'étendent sur plus qu'une période par symbole et font bien face à de multiples niveaux de modulation. Le signal mis en forme par ce filtre en cosinus surélevé se trouve dans une bande passante de l'ordre de 16 kHz.

Un formeur d'impulsions 21 typique, implémenté comme un filtre FIR, peut donc consister en une mémoire, qui enregistre les échantillons de la réponse impulsionnelle, des registres, qui agissent comme des portes à retard de signaux, et des circuits numériques combinatoires, tels que des additionneurs et multiplicateurs mettant en oeuvre la convolution. Dans des registres du formeur d'impulsions 21, il est ainsi possible de mémoriser différentes formes d'onde pour la modulation d'amplitude des données. Une forme d'onde mémorisée peut être spécifiquement sélectionnée. Les flancs de transition des données sont donc atténués ou lissés en sortie du formeur d'impulsions pour définir une courbe de transition de données de manière à réduire la largeur de bande des signaux RF ASK à transmettre par l'antenne du circuit de transmission.

Selon une seconde forme d'exécution moins coûteuse du formeur d'impulsions 21, il est possible pour former les impulsions du signal, de mémoriser dans la mémoire, pour chaque transition possible entre deux niveaux de modulation, une séquence de valeurs représentant la forme d'onde de transition atténuée. Pour ce faire, il est prévu une mémoire, qui enregistre les échantillons des formes d'onde de transition, et un circuit de commande numérique, qui détecte la transition à l'entrée et sélectionne la forme d'onde appropriée à la sortie. Si une transition est détectée à l'entrée du formeur d'impulsions 21, les échantillons de la forme d'onde correspondante sont successivement sortis au taux d'échantillonnage augmenté. Dans cette forme simple, la seconde forme d'exécution du formeur d'impulsions n'est pas capable de traiter les transitions, qui s'étendent au-dessus d'une période d'un symbole. De plus, comme le nombre de transitions possibles augmentent de manière quadratique avec le nombre de niveaux de modulation, ce procédé peut avoir besoin d'un plus grand espace mémoire que la première forme d'exécution du formeur d'impulsions.

La figure 5 représente différents graphiques temporels des signaux à l'entrée et à la sortie des composants électroniques de la partie numérique de l'unité pour former numériquement les impulsions de données pour la modulation d'amplitude des signaux RF à transmettre. Le signal numérique de données d ou flux de données binaires, qui est fourni au formeur d'impulsions, est représenté sur le premier graphique depuis le haut. Les différents symboles du signal numérique de données d sont définis sur la base d'un code bipolaire (bivalent) avec un niveau -1 pour définir un état "0" et avec un niveau +1 pour définir un état "1". Dans cet exemple, ce signal numérique de données d peut avoir un débit de données de l'ordre de 25 kBaud, c'est-à-dire 25'000 symboles par seconde. Chaque symbole est représenté sur le graphe par un rectangle dont le premier symbole est défini ici par un état "0" à -1. La succession de symboles sur ce premier graphe représente les données "01100000100110110000000000000001" et ainsi de suite en montrant bien la transition des données d'un état "0" à un état "1" et inversement par les lignes en traits interrompus.

Il est à noter que chaque symbole peut aussi être défini à plus que deux états. Chaque symbole peut être trivalent ou tétravalent également de manière à porter plus d'information à transmettre. Dans ces conditions, il faudrait un bus à plusieurs lignes numériques pour amener le signal numérique de données à l'entrée du formeur d'impulsions.

Le second graphe depuis le haut représente le signal numérique de données dₛ mis en forme par le formeur d'impulsions en passant à travers un filtre en cosinus surélevé implémenté comme un filtre du type FIR. Ce signal numérique de données mis en forme est échantillonné par le signal d'échantillonnage, dont la fréquence est par exemple 20 fois supérieure à la fréquence des données, c'est-à-dire à 500'000 échantillons par seconde. Comme le filtre FIR comprend un certain nombre de portes à retard, il y a inévitablement un écart temporel Δt pour chaque symbole représenté dans le signal numérique de données mis en forme dₛ par rapport à chaque symbole du signal numérique d'entrée d. Cet écart temporel Δt peut valoir plusieurs périodes du débit de données, soit de l'ordre de 0.1 ms. Il est normalement inférieur à 1 ms, et de préférence voisin de 0.1 ms.

Le premier symbole du signal numérique d'entrée, qui définit un état "0", n'intervient donc dans le signal numérique de données mis en forme qu'après un écart temporel Δt d'au moins 0.1 ms. Tous les échantillons sur 10 bits en sortie du formeur d'impulsions représentent une forme d'onde avec des flancs de transition atténués ou lissés des données sous la forme de courbes de transition. Cette forme d'onde numérique en sortie du formeur d'impulsions, qui est représentée au second graphe, correspond approximativement à la forme d'onde en analogique du signal de commande Vmod en sortie de l'unité.

Le troisième graphe depuis le haut représente le signal numérique de données dₑ mis en forme et après passage dans l'élément de pré-distorsion. Ce signal numérique, qui est fourni en entrée du modulateur sigma-delta, a subi une opération de sur-échantillonnage avec un signal d'échantillonnage à fréquence n fois supérieure de préférence 20 fois supérieure, à celle du signal d'échantillonnage pour le formeur d'impulsions. Dans ce cas, plus de 10'000'000 d'échantillons par seconde sont fournis dans ce signal numérique de données en sortie de l'élément de pré-distorsion. De préférence, il peut être prévu plus de 13'000'000 échantillons par seconde en fonction de la fréquence de référence de l'oscillateur local. Par contre par simplification, aucune pré-distorsion n'a été effectuée dans l'élément de pré-distorsion sur le troisième graphe. Cette forme d'onde numérique correspond également à la forme d'onde en analogique du signal de commande Vmod en sortie de l'unité pour commander la modulation d'amplitude des données dans l'amplificateur de puissance.

Il est à noter encore qu'un filtre d'interpolation peut être inséré entre le formeur d'impulsions et le modulateur sigma-delta. Ceci permet d'éliminer le repliement spectral en sortie du formeur d'impulsions.

Le quatrième graphe représente le signal numérique de sortie d_{sdm} du modulateur sigma-delta, qui est échantillonné à la même fréquence que l'élément de pré-distorsion. On remarque qu'à la sortie du quantificateur, le signal de sortie s'étale sur un nombre X de niveaux définis. Dans le cas représenté, ce signal numérique de sortie est représenté sur 7 niveaux. Les échantillons ainsi produits en sortie du modulateur sigma-delta sont représentés sur ces 7 niveaux entre -3 et +3. Des sauts très rapides d'un échantillon à l'autre entre ces niveaux s'opèrent sans qu'il soit possible de bien les visionner sur ce quatrième graphe étant donné que plus de 13'000'000 échantillons par seconde sont obtenus. Ce signal numérique sur 7 niveaux peut ensuite être fourni au convertisseur numérique-analogique. Ce convertisseur numérique-analogique est de réalisation simple comparativement à un convertisseur à résolution élevée, qui serait nécessaire, si on voulait convertir le signal sortant de l'élément de pré-distorsion directement sans modulation sigma-delta.

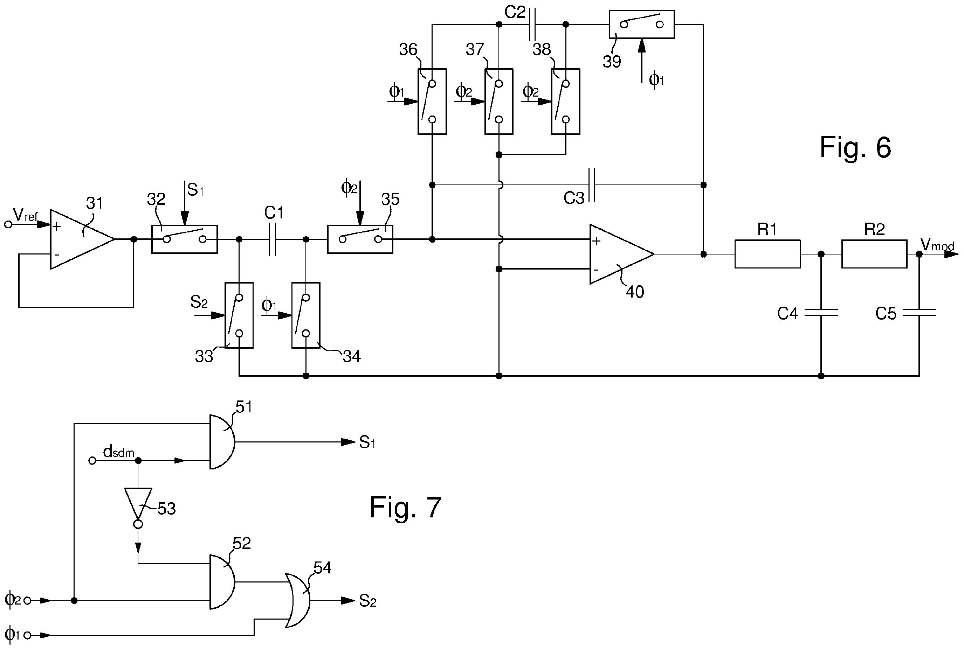

Il est bien clair que le modulateur sigma-delta peut fournir un signal numérique de sortie sur un nombre de niveaux inférieur, par exemple uniquement sur deux niveaux comme expliqué par la suite en référence à la figure 6 représentant le convertisseur numérique-analogique et le filtre passe-bas de sortie. Cela peut également dépendre de l'application envisagée pour le circuit de transmission de signaux RF ASK.

Une forme d'exécution du convertisseur numérique-analogique avec le filtre passe-bas de sortie est donc représentée sur la figure 6, ainsi que l'agencement électronique pour la génération des différents signaux de commutation du convertisseur sur la figure 7. Le convertisseur numérique-analogique est de conception traditionnelle et peut-être composé d'un réseau de capacités commutées en fonction du nombre de niveaux du signal numérique de sortie d_{sdm} fourni par le modulateur sigma-delta. Par simplification, ce signal numérique de sortie d_{sdm} n'est défini que sur deux niveaux pour expliquer la forme d'exécution du convertisseur numérique-analogique de la figure 6.

Le convertisseur numérique-analogique comprend un premier amplificateur opérationnel 31 monté sous la forme d'un suiveur en tension. Une tension de référence Vref est fournie à l'entrée de ce suiveur en tension 31. La tension de référence en sortie du suiveur en tension est fournie à travers un premier interrupteur 32 à une première borne d'un premier condensateur C1. Ce premier interrupteur 32 est commandé par un premier signal de commutation S₁ pour alterner entre une position fermée et une position ouverte à une fréquence correspondant à la fréquence du signal de référence de l'oscillateur local. Ce premier signal de commutation S₁ est défini par l'agencement électronique représenté à la figure 7 et expliqué ci-après.

Un second interrupteur 33 est relié entre la première borne du premier condensateur C1 et une borne de potentiel bas en dessous de la tension de référence Vref. Ce potentiel bas peut être également le potentiel de masse du circuit de transmission des signaux RF ASK. La valeur de ce potentiel bas sera choisie notamment en fonction de la réalisation de l'amplificateur opérationnel et de la dynamique de sortie désirée du signal de commande Vmod. Ce second interrupteur 33 est commandé par un second signal de commutation S₂ obtenu selon l'agencement électronique de la figure 7.

La seconde borne du premier condensateur C1 est reliée à un troisième interrupteur 34, dont la sortie est reliée à une borne de potentiel bas. Ce troisième interrupteur 34 est commandé par un troisième signal de commutation Φ₁, qui est un signal d'horloge à impulsions rectangulaires et à fréquence correspondant à la fréquence de référence de l'oscillateur local. Le troisième interrupteur 34 peut être fermé quand le troisième signal Φ₁ est à l'état "1", et ouvert quand le troisième signal Φ₁ est à l'état "0". La seconde borne du premier condensateur C1 est également reliée à un quatrième interrupteur 35, dont la sortie est reliée d'une part à une borne d'entrée positive d'un second amplificateur opérationnel 40, et d'autre part à une première borne d'un troisième condensateur C3 et d'un cinquième interrupteur 36. La seconde borne du troisième condensateur C3 est reliée à la sortie du second amplificateur opérationnel 40. La borne d'entrée négative du second amplificateur opérationnel 40 est reliée à la borne de potentiel bas.

Le quatrième interrupteur 35 est commandé par un quatrième signal de commutation Φ₂, qui est à l'état haut, quand le troisième signal de commutation Φ₁ est à un niveau bas, sans qu'il y ait de recouvrement de Φ₁ et Φ₂ à l'état haut. Le cinquième interrupteur 36 est, par contre, commandé par le troisième signal de commutation Φ₁ et est également relié en sortie à une première borne d'un second condensateur C2. Un sixième interrupteur 37 est monté entre la première borne du second condensateur C2 et la borne de potentiel bas, et il est commandé par le quatrième signal de commutation Φ₂.

Un septième interrupteur 38 est monté entre la seconde borne du second condensateur C2 et la borne de potentiel bas. Ce septième interrupteur 38 est commandé également par le quatrième signal de commutation Φ₂. Un huitième interrupteur 39 est encore relié entre la seconde borne du second condensateur C2 et la borne de sortie du second amplificateur opérationnel 40. Ce huitième interrupteur 39 est commandé par le troisième signal de commutation Φ₁.

Il est à noter que chaque interrupteur peut être réalisé au moyen d'un transistor de type MOS, dont la grille reçoit le signal de commutation correspondant. S'il s'agit d'un transistor du type NMOS, l'interrupteur est fermé quand la tension de grille est proche de la valeur haute de la tension d'alimentation, qui peut valoir 3.5 V, et l'inverse pour un transistor du type PMOS. De plus, pour effectuer une conversion avec un signal numérique de sortie du modulateur sigma-delta à un nombre de niveaux supérieur à 2, il y aura plusieurs condensateurs du type C1 en parallèle pour former un réseau à capacités commutées bien connu. Il faudrait effectivement 4 capacités commutées pour un signal numérique sur 5 niveaux.

Depuis la sortie du second amplificateur opérationnel 40, un filtre passe-bas est disposé et configuré à une fréquence de coupure de l'ordre de 100 kHz. Le filtre passe-bas n'a pas besoin d'être sélectif et peut, dès lors, être réalisé avec un nombre restreint de condensateurs et résistances. Ce filtre passe-bas est composé d'un premier filtre composé d'une première résistance R1 reliée à un quatrième condensateur C4, et d'un second filtre composé d'une seconde résistance R2 reliée à un cinquième condensateur C5. Une tension de modulation Vmod avec adaptation des flancs de transition des données est ainsi fournie en sortie du filtre passe-bas au noeud de connexion entre la seconde résistance R2 et le cinquième condensateur C5.

L'agencement électronique pour la génération des différents signaux de commutation est représenté à la figure 7. Le signal numérique de sortie du modulateur sigma-delta d_{sdm} est appliqué d'une part à une entrée d'une première porte logique ET 51 et d'autre part à une entrée d'une seconde porte logique ET 52 en passant à travers un inverseur 53. Le quatrième signal de commutation Φ₂ est appliqué également directement à une autre entrée de la première porte logique ET 51, ainsi qu'à une autre entrée de la seconde porte logique ET 52. La sortie de la première porte logique ET fournit le premier signal de commutation S₁. La sortie de la seconde porte logique ET 52 est reliée à une entrée d'une porte logique OU 54, qui reçoit à une autre entrée le troisième signal de commutation Φ₁. La sortie de la porte logique OU 54 fournit le second signal de commutation S₂.

A partir de la description qui vient d'être faite, plusieurs variantes du circuit de transmission de signaux radiofréquences à modulation d'amplitude des données peuvent être conçues par l'homme du métier sans sortir du cadre de l'invention définie par les revendications. En lieu et place d'un modulateur sigma-delta dans l'unité de mise en forme numérique des impulsions de données, il peut être utilisé un modulateur à modulation de largeur d'impulsions. Un tel modulateur PWM est plus simple qu'un modulateur sigma-delta, mais par contre est susceptible de générer plus de bruit de quantification.

## Revendications

1. Circuit (10) pour la transmission de signaux radiofréquences à modulation d'amplitude des données, le circuit comprenant :
un oscillateur local (11) pour générer un signal oscillant (RF_in) à fréquence porteuse déterminée,
une unité (13) de mise en forme des impulsions de données pour fournir un signal de commande (Vmod) de modulation en amplitude des données, l'unité (13) comprenant un formeur d'impulsions (21) pour adapter numériquement les flancs de transition des données sur la base d'un signal numérique de données (d) reçu, et un étage de conversion numérique-analogique (26, 27) pour convertir un signal numérique de données mis en forme dans l'unité, afin de fournir le signal de commande (Vmod) de modulation en amplitude des données, et
un amplificateur de puissance (12) recevant le signal oscillant (RF_in) de l'oscillateur local (11) et le signal de commande (Vmod) de modulation en amplitude des données de l'unité (13) de mise en forme des impulsions de données, pour la transmission de signaux radiofréquences à modulation d'amplitude des données par une antenne (14) ou un agencement d'antenne, où le formeur d'impulsions (21) comprend une memoire où plusieurs formes d'onde sont mémorisées, le formeur d'impulsions étant configuré pour pouvoir sélectionner individuellement chaque forme d'onde, sur la base du signal numérique de données, pour atténuer ou lisser numériquement tous les flancs de transition des données à transmettre dans les signaux radiofréquences à modulation d'amplitude des données.

2. Circuit (10) selon la revendication 1, **caractérisé en ce que** lesdites plusieurs formes d'onde sont mémorisées chacune dans un registre spécifique dans la mémoire, afin de pouvoir être sélectivement sélectionnée, et **en ce que** le formeur d'impulsions (21) sur la base du signal numérique de données reçu fournit un signal numérique de données (dₛ) mis en forme numériquement sur N bits, où N est un nombre 30 entier supérieur à 1.

3. Circuit (10) selon la revendication 2, **caractérisé en ce que** le formeur d'impulsions (21) est configuré pour fournir un signal numérique de données (dₛ) mis en forme numériquement sur N bits, tel que 10 bits, en étant échantillonné par un premier signal d'échantillonnage à fréquence m fois supérieur à la fréquence des données du signal numérique des données reçu, où m est un nombre entier supérieur ou égal à 2.

4. Circuit (10) selon l'une des revendications précédentes, **caractérisé en ce que** le formeur d'impulsions (21) comprend un filtre en cosinus surélevé implémenté sous la forme d'un filtre à réponse impulsionnelle finie pour mettre en forme les impulsions de données du signal numérique de données reçu.

5. Circuit (10) selon l'une des revendications précédentes, **caractérisé en ce que** l'étage de conversion numérique-analogique (26, 27) comprend un convertisseur numérique-analogique (26) et un filtre passe-bas non sélectif (27) pour fournir le signal de commande (Vmod) de modulation en amplitude des données à l'amplificateur de puissance (12).

6. Circuit (10) selon l'une des revendications précédentes, **caractérisé en ce que** l'unité (13) de mise en forme des impulsions de données comprend en outre un modulateur sigma-delta (23) disposé entre le formeur d'impulsions (21) et l'étage de conversion numérique-analogique (26, 27), ledit modulateur sigma-delta (23) comprenant un filtre de boucle (24) pour recevoir le signal numérique de données mis en forme par le formeur d'impulsions (21) et un quantificateur (25) pour recevoir le signal numérique filtré de données, afin de fournir un signal numérique quantifié en sortie (d_{sdm}) sur X niveaux définis à l'étage de conversion numérique-analogique (26, 27), où X est un nombre entier supérieur ou égal à 2.

7. Circuit (10) selon la revendication 6, **caractérisé en ce que** l'unité (13) de mise en forme des impulsions de données comprend en outre un élément de pré-distorsion (22) disposé entre le formeur d'impulsions (21) et le modulateur sigma-delta (23), **en ce que** l'élément de pré-distorsion comprend une mémoire avec une table de consultation paramétrable de manière à appliquer une caractéristique de transfert non linéaire au signal numérique de données mis en forme (dₛ) par le formeur d'impulsions (21) pour compenser toute distorsion sur le chemin des signaux de modulation, et fournir un signal numérique de données mis en forme et pré-distordu (dₑ) sur P bits au modulateur sigma-delta (23).

8. Circuit (10) selon la revendication 7, **caractérisé en ce que** le modulateur sigma-delta (23) opère sur la base d'un second signal d'échantillonnage à fréquence n fois supérieure à la fréquence d'échantillonnage d'un premier signal d'échantillonnage appliqué au formeur d'impulsions (21) et à l'élément de pré-distorsion (22), où n est un nombre entier supérieur ou égal à 2.

9. Circuit (10) selon la revendication 8, **caractérisé en ce que** l'oscillateur local (11) comprend un synthétiseur de fréquence muni d'un oscillateur de référence relié à un résonateur à quartz, ledit oscillateur de référence fournissant un signal de référence utilisé pour la fourniture du second signal d'échantillonnage à fréquence correspondant à la fréquence du signal de référence, et **en ce que** le premier signal d'échantillonnage du formeur d'impulsions est obtenu par le signal de référence à travers une série de diviseurs de fréquence de manière à avoir une première fréquence d'échantillonnage n fois inférieure à la fréquence du second signal d'échantillonnage, de préférence 20 fois inférieure.

10. Circuit (10) selon l'une des revendications 5 à 9, **caractérisé en ce que** le filtre passe-bas (27) non sélectif est adapté à une fréquence de coupure inférieure à la fréquence du bruit de quantification généré par le modulateur sigma-delta.

11. Circuit (10) selon la revendication 1, **caractérisé en ce que** l'amplificateur de puissance (12) comprend deux transistors de type MOS monté en série dans un montage cascode entre une borne de l'antenne (14) et une borne d'une source de tension d'alimentation, notamment une borne de masse, **en ce qu'**un premier des deux transistors MOS est commandé sur sa grille par le signal oscillant (RF_in) de l'oscillateur local (11), et **en ce qu'**un second des deux transistors MOS est commandé sur sa grille par le signal de commande (Vmod) de modulation en amplitude des données fourni par l'unité (13), ledit signal de commande (Vmod) étant une tension de commande ayant des flancs atténués de transition des données.

## Patentansprüche

1. Schaltung (10) zur Übertragung von Hochfrequenzsignalen mit Amplitudenmodulation der Daten, wobei die Schaltung umfasst:
einen lokalen Oszillator (11), um ein Oszillatorsignal (HF_in) mit bestimmter Trägerfrequenz zu erzeugen,
eine Datenimpulsformungseinheit (13) zum Bereitstellen eines Datenamplitudenmodulationssteuersignals (Vmod), wobei die Einheit (13) einen Impulsformer (21) zum digitalen Anpassen der Datenübergangsflanken auf Basis eines empfangenen digitalen Datensignals (d) und eine Digital/Analog-Wandlerstufe (26, 27) umfasst, um ein digitales Datensignal, das durch die Einheit geformt wird, zu wandeln, um das Steuersignal (Vmod) mit Amplitudenmodulation der Daten auszugeben, und
einen Leistungsverstärker (12), der das Oszillatorsignal (HF_in) des lokalen Oszillators (11) und das Steuersignal (Vmod) mit Amplitudenmodulation der Daten von der Einheit (13) zum Formen von Datenimpulsen empfängt, um über eine Antenne (14) oder eine Antennenanordnung Hochfrequenzsignale mit Amplitudenmodulation der Daten zu übertragen, wobei der Impulsformer (21) einen Speicher besitzt, in dem mehrere Wellenformen gespeichert sind, wobei der Impulsformer konfiguriert ist, jede Wellenform einzeln auf Basis des digitalen Datensignals auszuwählen zu können, um sämtliche Übergangsflanken der Daten, die in den Hochfrequenzsignalen mit Amplitudenmodulation der Daten übertragen werden sollen, digital zu dämpfen oder zu glätten.

2. Schaltung (10) nach Anspruch 1, **dadurch gekennzeichnet, dass** die mehreren Wellenformen jeweils in einem bestimmten Register in dem Speicher gespeichert sind, um gezielt ausgewählt werden zu können, und dass der Impulsformer (21) auf Basis des empfangenen digitalen Datensignals ein digitales Datensignal (dₛ) ausgibt, das digital über N Bits geformt ist, wobei N eine ganze Zahl größer als 1 ist.

3. Schaltung (10) nach Anspruch 2, **dadurch gekennzeichnet, dass** der Impulsformer (21) konfiguriert ist, ein digitales Datensignal (dₛ) auszugeben, das digital über N Bits, etwa 10 Bits, geformt ist, indem es durch ein erstes Abtastsignal mit einer Frequenz m-mal höher als die Frequenz der Daten des empfangenen digitalen Datensignals abgetastet wird, wobei m eine ganze Zahl größer oder gleich 2 ist.

4. Schaltung (10) nach einem der vorhergehenden Ansprüche, **dadurch gekennzeichnet, dass** der Impulsformer (21) ein hohes Kosinusfilter umfasst, das in Form eines Filters mit endlicher Impulsantwort implementiert ist, um die Datenimpulse des empfangenen digitalen Datensignals zu formen.

5. Schaltung (10) nach einem der vorhergehenden Ansprüche, **dadurch gekennzeichnet, dass** die Digital/Analog-Wandlerstufe (26, 27) einen Digital/Analog-Wandler (26) und ein nicht selektives Tiefpassfilter (27) umfasst, um das Steuersignal (Vmod) mit Amplitudenmodulation der Daten an den Leistungsverstärker (12) auszugeben.

6. Schaltung (10) nach einem der vorhergehenden Ansprüche, **dadurch gekennzeichnet, dass** die Einheit (13) zum Formen von Datenimpulsen weiterhin einen Sigma/Delta-Modulator (23) umfasst, der zwischen dem Impulsformer (21) und der Digital/Analog-Wandlerstufe (26, 27) angeordnet ist, wobei der Sigma/Delta-Modulator (23) ein Schleifenfilter (24) umfasst, um das digitale Datensignal, das durch den Impulsformer (21) geformt worden ist, zu empfangen, und einen Quantisierer (25) umfasst, um das gefilterte digitale Datensignal zu empfangen, um am Ausgang auf X Pegeln ein quantifiziertes digitales Signal (d_{sdm}) auszugeben, die in der Digital/Analog-Wandlerstufe (26, 27) definiert sind, wobei X eine ganze Zahl größer oder gleich 2 ist.

7. Schaltung (10) nach Anspruch 6, **dadurch gekennzeichnet, dass** die Einheit (13) zum Formen von Datenimpulsen weiterhin ein Vorverzerrungselement (22) umfasst, das zwischen dem Impulsformer (21) und dem Sigma/Delta-Modulator (23) angeordnet ist, dass das Vorverzerrungselement einen Speicher mit einer parametrisierbaren Abfragetabelle enthält, derart, dass eine nichtlineare Übertragungscharakteristik angewendet wird auf das digitale Datensignal (ds), das durch den Impulsformer (21) geformt wird, um jegliche Verzerrung auf dem Weg der Modulationssignale zu kompensieren und um ein geformtes und vorentzerrtes digitales Datensignal (dₑ) über P Bits an den Sigma/Delta-Modulator (23) auszugeben.

8. Schaltung (10) nach Anspruch 7, **dadurch gekennzeichnet, dass** der Sigma/Delta-Modulator (23) auf der Basis eines zweiten Abtastsignals mit einer Frequenz arbeitet, die n-mal höher als die Abtastfrequenz eines ersten Abtastsignals ist, das an den Impulsformer (21) und das Vorverzerrungselement (22) angelegt wird, wobei n eine ganze Zahl größer oder gleich 2 ist.

9. Schaltung (10) nach Anspruch 8, **dadurch gekennzeichnet, dass** der lokale Oszillator (11) einen Frequenzsynthesizer umfasst, der mit einem mit einem Quarz-Resonator verbundenen Referenzoszillator versehen ist, wobei der Referenzoszillator ein Referenzsignal ausgibt, das für die Ausgabe des zweiten Abtastsignals mit einer Frequenz, die der Frequenz des Referenzsignals entspricht, verwendet wird, und dass das erste Abtastsignal des Impulsformers durch das Referenzsignal über eine Reihe von Frequenzteilern erhalten wird, derart, dass eine erste Abtastfrequenz vorhanden ist, die n-mal niedriger, vorzugsweise 20 mal niedriger als die Frequenz des zweiten Abtastsignals ist.

10. Schaltung (10) nach einem der Ansprüche 5 bis 9, **dadurch gekennzeichnet, dass** das nicht selektive Tiefpassfilter (27) an eine Grenzfrequenz angepasst ist, die niedriger als die Frequenz des Quantisierungsrauschens ist, das durch den Sigma/Delta-Modulator erzeugt wird.

11. Schaltung (10) nach Anspruch 1, **dadurch gekennzeichnet, dass** der Leistungsverstärker (12) zwei Transistoren des MOS-Typs enthält, die in einer Kaskodenschaltung zwischen einem Antennenanschluss (14) und einem Anschluss einer Versorgungsspannungsquelle, insbesondere einem Masseanschluss, in Reihe geschaltet sind, dass ein erster der beiden MOS-Transistoren an seinem Gate durch das Oszillatorsignal (HF_in) des lokalen Oszillators (11) gesteuert wird und dass ein zweiter der beiden MOS-Transistoren an seinem Gate durch das Steuersignal (Vmod) mit Amplitudenmodulation der Daten gesteuert wird, das von der Einheit (13) geliefert wird, wobei das Steuersignal (Vmod) eine Steuerspannung ist, die gedämpfte Datenübergangsflanken besitzt.

## Claims

1. Data amplitude modulation circuit (10) for the transmission of radio frequency signals, the circuit including:
a local oscillator (11) for generating an oscillating signal (RF_in) at a determined carrier frequency,
a unit (13) for shaping data pulses to supply a data amplitude modulation control signal (Vmod), the unit (13) including a pulse shaper (21) for digitally adapting the data transition edges on the basis of an incoming digital data signal (d), and a digital-analogue conversion stage (26, 27) for converting a digital data signal shaped in the unit, so as to supply the data amplitude modulation control signal (Vmod) to the power amplifier (12). and
a power amplifier (12) receiving the oscillating signal (RF_in) from the local oscillator (11) and the data amplitude modulation control signal (Vmod) from the data pulse shaping unit (13), for the transmission of data amplitude modulated radio frequency signals by an antenna (14) or an antenna arrangement,
wherein the pulse shaper (21) includes a memory in which several wave shapes are stored, the pulse shaper being configured to be able to individually select each wave shape on the basis of the digital data signal, to digitally attenuate or smooth all the transition edges of the data to be transmitted in the data amplitude modulated radio frequency signals

2. Circuit (10) according to claim 1, **characterized in that** said several wave shapes each are stored in a specific register in the memory, so as to be selectively chosen, and **in that**, on the basis of the incoming digital data signal, the pulse shaper (21) supplies a digital data signal (dₛ) digitally shaped on N bits, where N is an integer number greater than 1.

3. Circuit (10) according to claim 2, **characterized in that** the pulse shaper (21) is configured to supply a digital data signal (dₛ) digitally shaped on N bits, such as 10 bits, and sampled by a first sampling signal at a frequency m times higher than the data frequency of the incoming digital data signal, where m is an integer number higher than or equal to 2.

4. Circuit (10) according to any of the preceding claims, **characterized in that** the pulse shaper (21) includes a raised cosine filter implemented in the form of a finite impulse response filter for shaping the data pulses of the incoming digital data signal.

5. Circuit (10) according to any of the preceding claims, **characterized in that** the digital-analogue conversion stage (26, 27) includes a digital-analogue converter (26) and a non-selective low-pass filter (27) for supplying the data amplitude modulation control signal (Vmod) to the power amplifier (12).

6. Circuit (10) according to any of the preceding claims, **characterized in that** the data pulse shaping unit (13) further includes a sigma-delta modulator (23) arranged between the pulse shaper (21) and the digital-analogue conversion stage (26, 27), said sigma-delta modulator (23) including a loop filter (24) for receiving the digital data signal shaped by the pulse shaper (21) and a quantifier (25) for receiving the filtered digital data signal, in order to supply a quantified digital output signal (d_{sdm}) on X defined levels to the digital-analogue conversion stage (26, 27), where X is an integer number greater than or equal to 2.

7. Circuit (10) according to claim 6, **characterized in that** the data pulse shaping unit (13) further includes a pre-distortion element (22) arranged between the pulse shaper (21) and the sigma-delta modulator (23), **in that** the pre-distortion element includes a memory with a reference table which can be set to apply a non-linear transfer characteristic to the digital data signal (dₛ) shaped by the pulse shaper (21) to compensate for any distortion on the path of the modulation signals, and to supply a shaped and pre-distorted digital data signal (dₑ) on P bits to the sigma-delta modulator (23).

8. Circuit (10) according to claim 7, **characterized in that** the sigma-delta modulator (23) operates on the basis of a second sampling signal at a frequency n times higher than the sampling frequency of a first sampling signal applied to the pulse shaper (21) and to the pre-distortion element (22), where n is an integer number greater than or equal to 2.

9. Circuit (10) according to claim 8, **characterized in that** the local oscillator (11) includes a frequency synthesiser provided with a reference oscillator connected to a quartz resonator, said reference oscillator supplying a reference signal used for the supply of the second sampling signal at a frequency matching the frequency of the reference signal, and **in that** the first sampling signal from the pulse shaper is obtained by the reference signal via a series of frequency dividers so as to obtain a first sampling frequency n times lower than the frequency of the second sampling signal, and preferably 20 times lower.

10. Circuit (10) according to any of claims 5 to 9, **characterized in that** the non-selective low-pass filter (27) is adapted to a cutoff frequency lower than the frequency of the quantification noise generated by the sigma-delta modulator.

11. Circuit (10) according to claim 1, **characterized in that** the power amplifier (12) includes two series connected MOS transistors in a cascode arrangement between a terminal of the antenna (14) and a terminal of a supply voltage source, particularly an earth terminal, **in that** a first of the two MOS transistors is controlled across the gate thereof by the oscillating signal (RF_in) from the local oscillator (11), and **in that** a second of the two MOS transistors is controlled across the gate thereof by the data amplitude modulation control signal (Vmod) supplied by the unit (13), said control signal (Vmod) being a control voltage having attenuated data transition edges.
